# EUROPÄISCHE PATENTSCHRIFT

(11) **EP 1 162 238 B1**
(45) Veröffentlichungstag und Bekanntmachung des Hinweises auf die Patenterteilung: **26.01.2005**
(21) Anmeldenummer: 01121781.7
(22) Anmeldetag: 24.04.1995
(51) Int. Cl.: C08L 81/02, C08K 5/20, C09D 181/02, H01B 1/12

(54) **Leitfähige Beschichtungen hergestellt aus Mischungen enthaltend Polythiophen und Lösemittel**
Conductive layers made from compositions containing polythiophene and solvent
Couches conductrices formées à partir de compositions contenant un polythiophène et un solvant

(30) Priorität: 06.05.1994 DE 4416117; 03.03.1995 DE 19507413
(43) Veröffentlichungstag der Anmeldung: 12.12.2001
(62) Teilanmeldung aus: 95106073.0
(73) Patentinhaber: BAYER AG, 51368 Leverkusen (DE)
(72) Erfinder: Jonas, Friedrich, Dr., 52066 Aachen (DE); Karbach, Alexander, Dr., 47800 Krefeld (DE); Muys, Bavo, B 2640 Mortsel (BE); van Thillo, Etienne, B 2910 Essen (BE); Wehrmann, Rolf, Dr., 47800 Krefeld (DE); Elschner, Andreas, Dr., 45479 Mülheim (DE); Dujardin, Ralf, Dr., 47877 Willich (DE)

(56) Entgegenhaltungen:
- EP-A- 0 593 111
- EP-A- 0 602 713

## Beschreibung

Auf dem Elektronikgebiet werden z. B. für LCD-Displays elektrisch leitfähige, transparente Elektroden benötigt. Bisher werden für diese Anwendungen meist mit Metalloxiden bedampfte Gläser oder Kunststofffolien verwendet. Besonders gute Eigenschaften haben ITO = Indium Zinnoxid bedampfte bzw. besputterte Materialien. Der Oberflächenwiderstand der ITO-Schichten liegt in der Größenordnung von <500 Ω/□.

Die Herstellung solcher Schichten durch Aufsputtern im Vakuum ist sehr aufwendig. Es besteht daher ein Bedarf an einem Material, das die Herstellung transparenter, gut leitfähiger Beschichtungen mit einfachen Auftragstechniken ermöglicht.

Die Herstellung leitfähiger Beschichtungen auf Basis organischer leitfähiger Materialien ist prinzipiell bekannt. So sind z. B. Beschichtungen aus Polypyrrol (EP-A 302 304) oder Polythiophenderivaten (EP-A 440 957) beschrieben. Diese Beschichtungen können mit einfachen Beschichtungsverfahren hergestellt werden, sind aber für viele Einsatzgebiete nicht leitfähig bzw. transparent genug.

Gegenstand der Erfindung sind leitfähige Beschichtungen gemäß dem Anspruch 1.

Die Mischungen können als dünne Schichten auf Substrate aufgebracht und durch Trocknen und Tempern in transparente und elektrisch leitende Schichten überführt werden.

Geeignete organische Verbindungen, die mindestens eine Amidgruppe enthalten, entsprechen der Formel (II) 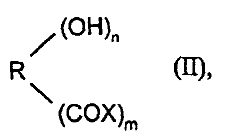 in der
- n und m: unabhängig voneinander eine ganze Zahl von 1 bis 20, bevorzugt von 2 bis 8 und
- R: einen linearen, verzweigten oder cyclischen Alkylenrest mit 2 bis 20 C-Atomen oder einen gegebenenfalls substituierten Arylenrest mit 6 bis 14 C-Atomen oder einen heterocyclischen Rest mit 4 bis 10 C-Atomen oder einen Zuckerrest bzw. Zuckeralkoholrest und
- X: -NYZ bedeuten, wobei Y und Z unabhängig voneinander Wasserstoff oder Alkyl, vorzugsweise Wasserstoff oder C₁-C₁₂-Alkyl bedeuten.

Geeignete Lactamgruppen enthaltende organische Verbindungen sind zB. N-Methylpyrrolidon, Pyrrolidon, Caprolactam, N-Methylcaprolactam, N-Octylpyrrolidon.

Als Lösungsmittel für die Polythiophen-Dispersionen kommen neben Wasser auch andere protische Lösungsmittel in Betracht, z.B. niedere Alkohole wie Methanol, Ethanol und Isopropanol sowie Mischungen von Wasser mit niederen Alkoholen und andere mit Wasser mischbaren organischen Lösungsmittel wie Aceton.

Die mittleren Teilchendurchmesser der Dispersionspartikel können bis 10 µm erreichen, bevorzugt bis 3 µm und ganz besonders bevorzugt bis 1 µm.

Die Polythiophene der wiederkehrenden Struktureinheit der Formel (I) sind bekannt (vgl. EP-A 440 958 und 339 340). Die Herstellung der Dispersionen bzw. Lösungen ist in EP-A 440 957 und DE-OS 4 211 459 beschrieben.

Die Polythiophene werden in der Dispersion bzw. Lösung in kationischer Form, wie sie z.B. durch Behandlung der neutralen Thiophene mit Oxidationsmitteln erhalten werden, eingesetzt. Übliche Oxidationsmittel wie Kaliumperoxodisulfat werden für die Oxidation verwendet. Durch die Oxidation erhalten die Polythiophene positive Ladungen, die in den Formeln nicht dargestellt sind, da ihre Zahl und ihre Position nicht einwandfrei feststellbar sind.

Die Zahl der wiederkehrenden Struktureinheiten der Formel (I) ist im Allgemeinen > 5.

Die Polythiophen-Dispersionen bzw. Lösungen enthalten, bezogen auf die Summe aus Polythiophenkationen und Polyanionen, d. h. bezogen auf den gesamten Feststoffgehalt der Lösung, 1 bis 100.000 Gew.-%, bevorzugt 10 bis 1.000 Gew.-%, der Hydroxy- bzw. Carbonsäuregruppen enthaltenden Verbindungen der Formel (II). Verbindungen der Formel (II), die in Wasser löslich sind, werden bevorzugt verwendet.

Den Beschichtungslösungen können zusätzlich organische, polymere Bindemittel und/oder organische, niedermolekulare Vernetzungsmittel zugegeben werden. Entsprechende Bindemittel sind z. B. in der EP-A 564 911 beschrieben.

Besonders zur Herstellung haftfester Schichten auf Glas können den Beschichtungslösungen Epoxisilane, wie in der EP-A 564 911 beschrieben, zugesetzt werden.

Die erfindungsgemäßen Beschichtungen können nach bekannten Verfahren, z.B. durch Aufsprühen, Aufrakeln, Tauchen, Aufbringen mit Walzenantragssystemen, Druckverfahren wie Tiefdruck, Siebdruck, Vorhanggießen hergestellt und bei Raumtemperatur oder bei Temperaturen bis 300°C, bevorzugt bis 200°C getrocknet werden.

An die Trocknung bei Temperaturen unter 100°C schließt sich eine separate Temperung und bei Trocknungstemperaturen oberhalb 100°C eine kombinierte Temperung der erfindungsgemäßen Schichten zur Erhöhung der elektrischen Leitfähigkeit an. Diese Temperung wird bei Temperaturen von 100°C bis 400°C, bevorzugt bis 250°C durchgeführt. Die Dauer der Temperung liegt zwischen 0,5 bis 3600 Sekunden, bevorzugt 1 bis 90 Sekunden.

Die Dicke der erfindungsgemäßen Beschichtungen ist je nach Einsatzzweck und Anforderungen an Transparenz und Leitfähigkeit 0,025 bis 250 µm, bevorzugt 0,05 bis 10 µm; der Oberflächenwiderstand 0,1 bis 2000 Ω/□, bevorzugt 1 bis 300Ω/□.

Die erfindungsgemäßen Beschichtungen werden auf Gebieten, die gute elektrische Leitfähigkeiten erfordern, eingesetzt, z.B. als Elektrode in Elektrolumineszenzanzeigen, in LCD-Anzeigen, in Feststoffelektrolytkondensatoren, zur Abscheidung von Metallen wie Kupfer Nickel, z. B. bei der Leiterplattenfertigung, in Solarzellen, in elektrochromen Anzeigen oder zur Abschirmung elektromagnetischer Strahlung bzw. zur Ableitung elektrischer Ladungen z. B. auf Bildröhren oder als Antikorrosionsbeschichtung auf Metallen, zur Herstellung von Touch Screens. Weitere Einsatzgebiete sind bilderzeugende Systeme, z.B. Silberhalogenidfotografie, trockene Bildsysteme, Elektrofotografie.

Die leitfähigen Schichten können gegebenenfalls mit weiteren Schichten, z.B. UV härtenden oder organischen bzw. anorganischen Kratzfestbeschichtungen beschichtet werden.

Die erfindungsgemäßen Schichten können auf organische und auf anorganische Trägermaterialien aufgebracht werden. Geeignete anorganische Trägermaterialien sind z.B. Glas, Oxide bzw. oxidische oder nicht oxidische Keramiken wie Aluminiumoxid, Siliciumnitrid. Geeignete organische Trägermaterialien sind z.B. Folien oder andere Formkörper aus reinen organischen Polymeren, Copolymeren oder Mischungen von z.B. Polycarbonat, Polystyrol, Polyacrylaten, Polyestern wie Polyethylenterephthalat, Polybutylenterephthalat, Polyethylennaphthalat, Polyamiden, Polyimiden, gegebenenfalls glasfaserverstärkten Epoxidharzen, Cellulosederivaten wie Cellulosetriacetat, Polyolefinen wie Polyethylen, Polypropylen.

Gegenstand der Erfindung sind weiterhin elektrolumineszierende Anordnungen, die als transparente und leitfähige Schicht bzw. Elektrode die erfindungsgemäßen Beschichtungen aufweisen.

Die erfindungsgemäßen elektrolumineszierenden Anordnungen bestehen aus einer oberen und einer unteren Elektrode, zwischen die eine elektrolumineszierende Schicht und gegebenenfalls weitere Hilfsschichten, z.B. ladungsinjizierende Schichten, eingefügt werden, und sind dadurch gekennzeichnet, dass sie als Elektrode eine erfindungsgemäße leitfähige Schicht aus den Polythiophen- Mischungen aufweisen.

Die elektrolumineszierende Anordnung kann eine oder mehrere Elektroden enthalten, deren leitfähige Schicht die oben genannten Polythiophen-Dispersionen aufweisen. Die leitfähige Schicht ist vorzugsweise transparent.

Beim Aufbau der elektrolumineszierenden Anordnungen kann die leitfähige Schicht an unterschiedlichen Stellen integriert werden. So kann die leitfähige Schicht als transparente und leitfähige Elektrode zwischen einem transparenten Substrat und einer elektrolumineszierenden Schicht aufgebracht sein.

Dazu wird bei den erfindungsgemäßen Systemen die Mischung auf einem geeigneten Substrat als Film verteilt.

Als Substrat sind transparente Träger wie Glas oder Kunststoff-Folien (z.B. Polyester, wie Polyethylenterephthalat oder Polyethylennaphthalat, Polycarbonat, Polyacrylat, Polysulfon, Polyimid-Folie) geeignet.

Die Polythiophen-Mischung wird durch Techniken wie Spincoaten, Casting, Rakeln, Drucken, Vorhanggießen etc. auf dem Substrat gleichmäßig verteilt.

Nach Trocknen des Films kann das so beschichtete Substrat einer Temperatur von 150-250°C für mindestens 1 sec, in der Regel 30 sec ausgesetzt werden. Dieser Temperschritt führt zu einer Erhöhung der Schichtleitfähigkeit.

Die Dicke der transparenten leitfähigen Elektrode beträgt 5 nm bis mehrere µm, vorzugsweise 10 nm bis 1500 nm.

Auf diese leitfähige transparente Elektrode wird eine elektrolumineszierende Schicht als dünner Film aufgebracht. Die z.B. in EP-A 443 861 beschriebenen Substanzen können als elektrolumineszierende Substanzen verwendet werden.

Nach dem Trocknen der El-Schicht wird diese mit einer Gegenelektrode ausgerüstet. Diese besteht aus einer leitfähigen Substanz, die transparent sein kann. Vorzugsweise eignen sich Metalle wie Al, Au, Ag, etc. oder deren Legierungen und Oxide, die durch Techniken wie Aufdampfen, Aufputtern, Platinierung aufzubringen sind.

Die erfindungsgemäße Anordnung wird durch zwei elektrische Zuführungen (z.B. Metalldrähte) mit den beiden Elektroden in Kontakt gebracht.

Die Anordnungen emittieren beim Anlegen einer Gleichspannung im Bereich von 2 bis 100 Volt Licht der Wellenlänge von 400 bis 700 nm. Sie zeigen im Bereich von 400 bis 700 nm Photolumineszenz.

Die elektrolumineszierende Schicht kann eine oder mehrere elektrooptisch aktive Substanzen enthalten. Sie enthält gegebenenfalls weiterhin übliche Zusätze wie inerte Binder, ladungsträgertransportierende Substanzen. Ladungsträgertransportierende Substanzen erhöhen die Elektrolumineszintensität und reduzieren die Einsatzspannungen.

Als inerte Binder werden vorzugsweise löslich transparente Polymere wie z.B. Polycarbonate, Polystyrol und Copolymere des Polystyrols wie SAN, Polysulfone, Polyacrylate, Polyvinylcarbazol, Vinylacetat- und Vinylalkoholpolymere und -copolymere usw. eingesetzt.

Zwischen den elektrolumineszierenden Systemen und den Elektroden können zusätzlich eine oder mehrere Zwischenschichten angeordnet sein. Diese Zwischenschichten - ladungsträgertransportierende Substanzen - sind bekannt (z.B. aus Appl. Phys. Lett. 57 (1990) 531) und werden dort als HTL (hole transport lay) und als ETL (elektron transport layer) bezeichnet.

Die leitfähigen Schichten können ebenfalls als transparente und leitfähige Elektrode in Form einer Deckschicht auf einer elektrolumineszierenden Schicht aufgebracht sein.

In Gegensatz zu der vorher beschriebenen Anordnung, bei der sich die erfindungsgemäße Mischung zwischen einer elektrolumineszierenden Schicht und einem transparenten Träger befindet, kann die erfindungsgemäße Substanz auch als Deckelelektrode eingesetzt werden.

Bei dieser Anwendung befindet sich die elektrolumineszierende Substanz auf einem leitfähigen oder leitfähigbeschichtetem Träger. Dies können z.B. Metallplatten oder Metallbedampfungen sein. Die erfindungsgemäße Substanz wird analog der oben beschriebenen Art auf die elektroluminesizierende Schicht aufgebracht.

Der Vorteil dieser Anordnung ist, dass auf diese Weise auch elektrolumineszierende Schichten, die bei der Herstellung einer großen Wärmebelastung ausgesetzt sind, mit einer einfach applizierbaren, transparenten und leitfähigen Elektrode versehen werden können.

Beispiel: Leuchtplatten aus Leuchtstoffemails auf Basis von ZnS.

Die erfindungsgemäßen Beschichtungen können weiterhin als ladungstransportierende Zwischenschicht in polymeren Leuchtdioden eingesetzt werden. Durch diese Zwischenschicht wird die Effizienz der Anordnungen erhöht.

Die Mischung wird in oben beschriebener Art als Zwischenschicht aufgebracht. Die Zwischenschicht kann sich befinden:
- zwischen der transparenten leitfähigen Elektrode und der elektrolumineszierenden Polymerschicht,
- zwischen der elektrolumineszierenden Polymerschicht und der Deckelektrode.

Die Dicke der Zwischenschicht beträgt etwa 3 - 200 nm, in der Regel 10 nm - 100 nm, besonders bevorzugt ca. 10 nm.

### Beispiel

### A) Herstellung der 3,4-Polyethylendioxythiophenlösung.

20 g freie Polystyrolsulfonsäure (Mn ca. 40000) 13,0 g Kaliumperoxodisulfat und 50 mg Eisen(III)-sulfat werden unter Rühren in 2000 ml Wasser vorgelegt. Unter Rühren werden 5,6 g 3,4-Ethylendioxythiophen zugegeben. Die Lösung wird 24 h bei Raumtemperatur gerührt. Anschließend werden 100 g Anionenaustauscher (Handelsprodukt Bayer AG Lewatit MP 62) und 100 g Kationenaustauscher (Handelsprodukt Bayer AG Lewatit S 100), beide wasserfeucht, zugegeben und 8 Stunden gerührt.

Die Ionenaustauscher werden durch Filtration entfernt. Es wird eine Lösung mit einem Feststoffgehalt von ca. 1,2 Gew.-% erhalten, die gebrauchsfertig ist.

## Patentansprüche

1. Leitfähige Beschichtung hergestellt aus Mischungen enthaltend
A) eine Lösung oder Dispersion eines Polythiophenes in kationischer Form und Polyanionen, wobei das Polythiophen wiederkehrende Struktureinheiten der Formel (I) 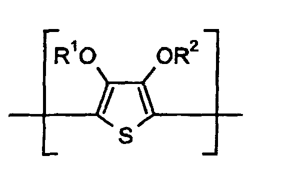 enthält, in der
R₁ und R₂ unabhängig voneinander für Wasserstoff oder eine C₁₋₄-Alkylgruppe stehen oder zusammen einen gegebenenfalls substituierten C₁₋₄-Alkylenrest, vorzugsweise einen gegebenenfalls durch Alkylgruppen substituierten Methylen-, einen gegebenenfalls. durch C₁₋₁₂-Alkyl- oder Phenylgruppen substituierten Ethylen-1,2-Rest oder einen Cyclohexylen-1,2-Rest bilden, und
B) mindestens eine Amidgruppe oder mindestens eine Lactamgruppe enthaltende organische Verbindungen
**dadurch gekennzeichnet, dass** sie zur Erhöhung der Leitfähigkeit nach Trocknung bei Temperaturen unter 100°C bei Temperaturen von 100°C bis 400°C getempert oder bei Trocknung bei Temperaturen oberhalb 100°C einer kombinieren. Temperung bei Temperaturen von 100°C bis 400°C unterzogen worden ist und der Oberflächenwiderstand 0,1 bis 2000 Ω/□ ist.

2. Leitfähige Beschichtung nach Anspruch 1, **dadurch gekennzeichnet, dass** es sich bei den organischen Verbindungen B) um N-Methylpyrrolidon, Pyrrolidon, Caprolactam, , N-Methylcaprolactam oder N-Octylpyrrolidon handelt.

3. Verwendung der leitfähigen Beschichtungen nach Anspruch 1 als ladungstransportierende Zwischenschicht in polymeren Leuchtdioden.

4. Elektrolumineszierende Anordnung, bestehend aus einer oberen und einer unteren Elektrode, zwischen die eine elektrolumineszierende Schicht und gegebenenfalls weitere Hilfsschichten eingefügt werden, **dadurch gekennzeichnet, dass** als Elektrode eine leitfähige Schicht gemäß Anspruch 1 verwendet wird.

## Claims

1. Conductive coating produced from mixtures containing
A) a solution or dispersion of a polythiophene in cationic form and polyanions, wherein the polythiophene contains repeating structural units of the formula (I) 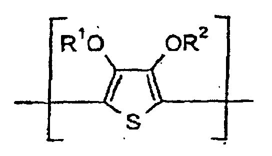 in which
R¹ and R² independently of one another denote hydrogen or a C₁₋₄-alkyl group or together form an optionally substituted C₁₋₄-alkylene radical, preferably a methylene radical optionally substitute by alkyl groups, an ethylene-1,2 radical or a cyclohexylene-1,2 radical optionally substituted by C₁₋₁₂-alkyl groups or phenyl groups, and
B) organic compounds containing at least one amide group or at least one lactam group,
**characterised in that** in order to increase the conductivity, after drying at temperatures below 100°C the coating is heat treated at temperatures of 100°C to 400°C, or on drying at temperatures above 100°C is subjected to a combined heat treatment at temperatures of 100°C to 400°C, and the surface resistance is 0.1 to 2000 Ω/□.

2. Conductive coating according to claim 1, **characterised in that** the organic compounds B) are N-methylpyrrolidone, pyrrolidone, caprolactam, N-methylcaprolactam or N-octylpyrrolidone.

3. Use of the conductive coatings according to claim 1 as charge-transporting intermediate layer in polymeric light-emitting diodes.

4. Electroluminescing arrangement consisting of an upper electrode and a lower electrode between which an electroluminescing layer and optionally further auxiliary layers are inserted, **characterised in that** a conductive layer according to claim 1 is used as electrode.

## Revendications

1. Revêtement conducteur préparé à partir de mélanges contenant:
A) une solution ou dispersion d'un polythiophène sous forme cationique et de polyanions, le polythiophène contenant des unités structurelles récurrentes de formule (I) 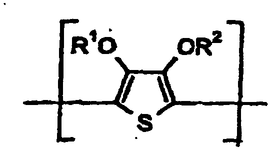 dans laquelle
R1 et R2 désignent, indépendamment l'un de l'autre, de l'hydrogène ou un radical C1-C4-alkyle ou, ensemble, un radical C1-C4-alkylène éventuellement substitué, de préférence un radical méthylène, éventuellement substitué par des radicaux alkyle, un radical éthylène-1,2 éventuellement substitué par des radicaux C1-C12-alkyle ou phényle ou un radical cyclohexylène-1,2 et
B) des composés organiques contenant au moins un radical amide ou au moins un radical lactame,
**caractérisé en ce qu'**après séchage à des températures inférieures à 100°C, il a été fritté à des températures de 100°C à 400°C en vue d'augmenter sa conductibilité ou, après séchage à des températures supérieures à 100°C, il a été soumis à un frittage combiné à des température de 100°C à 400°C et la résistance de surface est de 0,1 à 2000 Ω/□.

2. Revêtement conducteur selon la revendication 1, **caractérisé en ce que** les composés organiques B) sont la N-méthylpyrrolidone, la pyrrolidone, le caprolactame, le N-méthylcaprolactame ou la N-octylpyrrolidone.

3. Mise en oeuvre des revêtements conducteurs selon la revendication 1, comme couche intermédiaire de transport de charge dans des diodes luminescentes polymères.

4. Dispositif électroluminescent composé d'une électrode supérieure et d'une électrode inférieure entre lesquelles sont insérées une couche électroluminescente et, éventuellement, d'autres couches accessoires, **caractérisé en ce qu'**une couche conductrice selon la revendication 1 est utilisée comme électrode.
